# EUROPEAN PATENT APPLICATION

(11) **EP 4 848 963 A1**
(43) Date of publication of application: **02.12.2026**
(21) Application number: 24925460.8
(22) Date of filing: 20.08.2024
(51) Int. Cl.: H10N 30/30, H10N 30/50, G01N 29/00, H10N 30/05

(54) **ULTRASONIC SENSOR, ELECTRONIC DEVICE AND PREPARATION METHOD FOR ULTRASONIC SENSOR**

(30) Priority: 21.02.2024 CN 202410198120
(71) Applicant: HUAWEI TECHNOLOGIES CO., LTD., Shenzhen, Guangdong 518129 (CN)
(72) Inventor: PANG, Yu, Shenzhen, Guangdong 518129 (CN); CHEN, Xuying, Shenzhen, Guangdong 518129 (CN); YU, Yuanyuan, Shenzhen, Guangdong 518129 (CN); GAO, Wei, Shenzhen, Guangdong 518129 (CN); FENG, Pengfei, Shenzhen, Guangdong 518129 (CN)
(74) Representative: Goddar, Heinz J.
(86) International application number: PCT/CN2024/113478
(87) International publication number: WO 2025/175719

(57) **Abstract**

An ultrasonic sensor, an electronic device, and a method for fabricating an ultrasonic sensor are provided, and relate to the field of electronic device technologies. The ultrasonic sensor includes a substrate, a plurality of piezoelectric layers, and a plurality of electrode layers. The piezoelectric layers and the electrode layers are alternately stacked, and each piezoelectric layer is disposed between two adjacent electrode layers. Curie temperatures of the piezoelectric layers gradually decrease in a direction away from the substrate. In the provided ultrasonic sensor, the piezoelectric layers exhibit stable polarization and a high degree of polarization, thereby effectively improving performance of the ultrasonic sensor.

## Description

This application claims priority to Chinese Patent Application No. 202410198120.0, filed with the China National Intellectual Property Administration on February 21, 2024 and entitled "ULTRASONIC SENSOR, ELECTRONIC DEVICE, AND METHOD FOR FABRICATING ULTRASONIC SENSOR", which is incorporated herein by reference in its entirety.

### TECHNICAL FIELD

This application relates to the field of electronic device technologies, and in particular, to an ultrasonic sensor, an electronic device, and a method for fabricating an ultrasonic sensor.

### BACKGROUND

In an ultrasonic sensor, an ultrasonic transceiver may be configured to send ultrasonic waves to a to-be-detected object through an ultrasonic transmission medium, and receive ultrasonic waves reflected back from the to-be-detected object, thereby completing detection of the to-be-detected object.

For example, in a fingerprint ultrasonic sensor, ultrasonic waves emitted by an ultrasonic transceiver may be sent to a finger, and reflected back to the ultrasonic transceiver with different intensities at ridges and valleys of a fingerprint. A reflected signal may be processed to generate a fingerprint image, to complete acquisition and identification of the fingerprint image.

However, with diversification of application scenarios, higher performance of the ultrasonic sensor is required.

### SUMMARY

Embodiments of this application provide an ultrasonic sensor, an electronic device, and a method for fabricating an ultrasonic sensor, to ensure that a piezoelectric layer has a high degree of polarization, thereby improving performance of the ultrasonic sensor.

To achieve the foregoing objectives, the following technical solutions are used in embodiments of this application.

According to a first aspect, an ultrasonic sensor is provided, where the ultrasonic sensor includes a substrate, a plurality of piezoelectric layers, and a plurality of electrode layers.

The plurality of piezoelectric layers and the plurality of electrode layers are disposed on a same side of the substrate, the piezoelectric layers and the electrode layers are alternately stacked, and each piezoelectric layer is disposed between two adjacent electrode layers. Curie temperatures of the piezoelectric layers gradually decrease in a direction away from the substrate.

According to the ultrasonic sensor provided in this embodiment of this application, the Curie temperatures of the plurality of piezoelectric layers are set to gradually decrease in the direction away from the substrate, so that the plurality of piezoelectric layers exhibit a gradient in the Curie temperatures. This allows an annealing temperature of a piezoelectric layer fabricated later to be easily set between a Curie temperature of a piezoelectric layer fabricated earlier and a Curie temperature of the piezoelectric layer fabricated later, to prevent the piezoelectric layer fabricated earlier from undergoing depolarization during annealing of the piezoelectric layer fabricated later. In this way, it is ensured that each piezoelectric layer has a high degree of polarization, and it is ensured that the piezoelectric layer has good piezoelectric effect during operation of the ultrasonic sensor. For example, intensity of an ultrasonic wave generated by the piezoelectric layer can be increased, thereby improving performance of the ultrasonic sensor.

In a possible implementation of the first aspect, a difference between Curie temperatures of two adjacent piezoelectric layers is 5°C to 20°C. It can be ensured that all piezoelectric layers have good piezoelectric effect.

In a possible implementation of the first aspect, an annealing temperature of a piezoelectric layer farther away from the substrate is less than a Curie temperature of a piezoelectric layer closer to the substrate. On one hand, it can be ensured that the piezoelectric layer farther away from the substrate is fully annealed, and a degree of polarization of the piezoelectric layer is ensured. On the other hand, it is ensured that the piezoelectric layer farther away from the substrate does not cause depolarization of the piezoelectric layer closer to the substrate in a high-temperature annealing process, thereby ensuring that all piezoelectric layers have the good piezoelectric effect.

In a possible implementation of the first aspect, an electrode layer located between the two adjacent piezoelectric layers is a preset electrode layer, a thickness of the preset electrode layer is less than or equal to 0.1λ₁, and λ₁ is a wavelength of a sound wave passing through the preset electrode layer. In this way, an acoustic transparent layer is formed, so that a sound wave generated by the piezoelectric layer or a sound wave reflected by a to-be-detected object can almost pass through the preset electrode layer without loss, thereby avoiding an increase in a loss during sound wave transmission caused by the preset electrode layer located between the two piezoelectric layers, and further improving performance of the ultrasonic sensor.

In a possible implementation of the first aspect, in the plurality of electrode layers, a thickness of each electrode layer is less than or equal to 0.1λ, and λ is a wavelength of a sound wave passing through the electrode layer. In other words, in the plurality of electrode layers, a thickness of each electrode layer is one tenth of the wavelength of the sound wave passing through the electrode layer, so that the sound wave generated by the piezoelectric layer or the sound wave reflected by the to-be-detected object can almost pass through all the electrode layers without loss, thereby further reducing a loss during sound wave transmission in the ultrasonic sensor, and further improving performance of the ultrasonic sensor.

In a possible implementation of the first aspect, a sum of a thickness-to-wavelength ratio of the plurality of piezoelectric layers and a thickness-to-wavelength ratio of the plurality of electrode layers is 0.15N to 0.35N, and N is an odd number.

The sum of the thickness-to-wavelength ratios of the plurality of piezoelectric layers and the thickness-to-wavelength ratios of the plurality of electrode layers is set to 0.15N to 0.35N, so that the ultrasonic sensor forms a resonator approximating an odd multiple of a quarter wavelength. In this way, ultrasonic waves emitted by different piezoelectric layers can be effectively superimposed, to enhance sound pressure emission intensity of the ultrasonic sensor. In addition, an overall thickness of the ultrasonic sensor can be controlled to be within a relatively small range, thereby reducing attenuation of ultrasonic waves in each film layer and further improving the performance of the ultrasonic sensor.

In a possible implementation of the first aspect, the sum of the thickness-to-wavelength ratio of the plurality of piezoelectric layers and the thickness-to-wavelength ratio of the plurality of electrode layers is 0.25N, and N is an odd number. In other words, the ultrasonic sensor is configured to form a resonator that is an odd multiple of a quarter wavelength, thereby improving performance of the ultrasonic sensor.

In a possible implementation of the first aspect, a sum of a thickness-to-wavelength ratio of the substrate, the thickness-to-wavelength ratio of the plurality of piezoelectric layers, and the thickness-to-wavelength ratio of the plurality of electrode layers is 0.35M to 0.65M, and M is an integer. In other words, the overall structure of the ultrasonic sensor is close to a resonator that is an integer multiple of a half wavelength, which further facilitates superposition of ultrasonic waves, thereby enhancing resonance effect, that is, enhancing electrical performance of the ultrasonic sensor.

In a possible implementation of the first aspect, the ultrasonic sensor further includes a protective layer, where the protective layer is stacked on a side that is of an electrode layer farthest away from the substrate and that faces away from the substrate, and the protective layer is insulated from the electrode layer. Providing the protective layer can improve strength and a signal-to-noise ratio of the ultrasonic sensor.

In a possible implementation of the first aspect, a material of the protective layer includes a metal material.

In a possible implementation of the first aspect, from the protective layer to the electrode layer closest to the substrate, a sum of thickness-to-wavelength ratios of all film layers is 0.15N to 0.35N, and N is an odd number.

In a possible implementation of the first aspect, the ultrasonic sensor further includes a contact layer, where the contact layer is stacked on a side of the substrate that faces away from the protective layer, or is stacked on a side of the protective layer that faces away from the substrate. In other words, the contact layer may be attached in a positive or reverse manner, and the contact layer protects a key structure of the ultrasonic sensor from being damaged by a to-be-detected object.

In a possible implementation of the first aspect, the ultrasonic sensor further includes a circuit layer, where the circuit layer is disposed between the electrode layer closest to the substrate and the substrate, and the circuit layer includes a plurality of spaced pixel circuits. In the plurality of electrode layers, the electrode layer closest to the substrate includes a plurality of spaced electrode blocks, and the plurality of electrode blocks are correspondingly electrically connected to the plurality of pixel circuits. In this way, image restoration of the to-be-detected object is implemented.

In a possible implementation of the first aspect, in the plurality of electrode layers, two spaced electrode layers are electrically connected, and one electrode layer is disposed between the two electrode layers that are electrically connected. In this way, two sides of the piezoelectric layer between the two adjacent electrode layers have different electric potentials, thereby triggering piezoelectric effect of the piezoelectric layer.

In a possible implementation of the first aspect, the ultrasonic sensor further includes a first side edge trace and a second side edge trace, where the first side edge trace and the second side edge trace are respectively disposed on two sides of the plurality of electrode layers in a first direction, and the first direction is parallel to the substrate. The plurality of electrode layers include a plurality of first sublayers and a plurality of second sublayers, where the first sublayers and the second sublayers are alternately stacked. Two adjacent first sublayers are electrically connected through the first side edge trace, and two adjacent second sublayers are electrically connected through the second side edge trace. The first side edge trace is insulated from the second sublayer, and the second side edge trace is insulated from the first sublayer.

According to a second aspect, a method for fabricating an ultrasonic sensor is provided, where the fabrication method includes:
forming a plurality of electrode layers and a plurality of piezoelectric layers on a same side of a substrate, where the electrode layers and the piezoelectric layers are alternately stacked, each piezoelectric layer is disposed between two adjacent electrode layers, and Curie temperatures of the piezoelectric layers gradually decrease in a direction away from the substrate; and
forming the piezoelectric layer includes: forming a piezoelectric thin film; annealing the piezoelectric thin film, where an annealing temperature of a piezoelectric thin film farther away from the substrate is less than a Curie temperature of a piezoelectric thin film closer to the substrate; and polarizing the piezoelectric thin film to form the piezoelectric layer.

According to a third aspect, an electronic device is provided, where the electronic device includes a circuit board and the ultrasonic sensor provided in any embodiment of the first aspect. The circuit board is coupled to the ultrasonic sensor.

For technical effect brought by the fabrication method in the second aspect and the electronic device in the third aspect, refer to the technical effect brought by the design manner of the ultrasonic sensor in the first aspect. Details are not described herein again.

### BRIEF DESCRIPTION OF DRAWINGS

FIG. 1 is a diagram of a structure of an electronic device according to an embodiment of this application;
FIG. 2 is a sectional view of an electronic device according to an embodiment of this application;
FIG. 3 is a sectional view of an ultrasonic sensor according to an embodiment of this application;
FIG. 4 is another sectional view of an ultrasonic sensor according to an embodiment of this application;
FIG. 5 is still another sectional view of an ultrasonic sensor according to an embodiment of this application;
FIG. 6 is yet another sectional view of an ultrasonic sensor according to an embodiment of this application;
FIG. 7 is still yet another sectional view of an ultrasonic sensor according to an embodiment of this application;
FIG. 8 is further another sectional view of an ultrasonic sensor according to an embodiment of this application;
FIG. 9 is a thickness-acoustic transmittance curve diagram of an electrode layer;
FIG. 10 is further another sectional view of an ultrasonic sensor according to an embodiment of this application;
FIG. 11 is further another sectional view of an ultrasonic sensor according to an embodiment of this application;
FIG. 12 is further another sectional view of an ultrasonic sensor according to an embodiment of this application;
FIG. 13 is a frequency-sound pressure curve diagram of a protective layer;
FIG. 14 is a flowchart of fabricating an ultrasonic sensor according to an embodiment of this application; and
FIG. 15 is a flowchart of fabricating a piezoelectric layer according to an embodiment of this application.

### DESCRIPTION OF EMBODIMENTS

The following clearly and completely describes technical solutions in some embodiments of this application with reference to accompanying drawings. It is clear that the described embodiments are merely some rather than all embodiments of this application. All other embodiments obtained by a person of ordinary skill in the art based on embodiments of this application shall fall within the protection scope of this application.

In descriptions of this application, it should be understood that orientations or position relationships indicated by terms such as "center", "above", "below", "front", "rear", "left", "right", "vertical", "horizontal", "top", "bottom", "inside", and "outside" are based on the orientations or the position relationships shown in the accompanying drawings, and are merely intended to describe this application and simplify the descriptions, but not intended to indicate or imply that an indicated apparatus or element shall have a specific direction or be constructed and operated in a specific orientation. Therefore, such terms cannot be understood as a limitation on this application.

Unless otherwise required in the context, throughout the entire specification and claims, the term "include" is interpreted as "being open and inclusive", that is, "include but not limited to". In descriptions of this specification, terms such as "an embodiment", "some embodiments", "an example embodiment", "an example", or "some examples" are intended to indicate that a specific feature, structure, material, or characteristic related to embodiments or examples are included in at least one embodiment or example of this application. The foregoing schematic representations of the terms do not necessarily refer to a same embodiment or example. In addition, the specific feature, structure, material, or characteristic may be included in any one or more embodiments or examples in any appropriate manner.

The terms "first" and "second" mentioned below are merely intended for a purpose of description, and shall not be understood as an indication or implication of relative importance or implicit indication of a quantity of indicated technical features. Therefore, a feature limited by "first" or "second" may explicitly or implicitly include one or more features. In the descriptions of embodiments of this application, unless otherwise specified, "a plurality of" means two or more than two.

Connection/connecting may mean a mechanical connection relationship or a physical connection relationship, that is, that A and B are connected or that A is connected to B may mean that there is a fastening component (such as a screw, a bolt, or a rivet) between A and B, or A and B are in contact with each other and are difficult to be separated. A and B may be fastened, may be detachably connected, may be integrated, may be directly connected, or may be indirectly connected through an intermediate medium.

Coupling: Coupling may be understood as direct coupling and/or indirect coupling. A "coupling connection" may be understood as a direct coupling connection and/or an indirect coupling connection. The direct coupling may also be referred to as an "electrical connection" and may be understood as physical contact and electrical conduction of components, for example, a form in which different components in a line structure are connected through physical lines that can transmit an electrical signal, such as a printed circuit board (printed circuit board, PCB) copper foil or a conducting wire. The "indirect coupling" may be understood as electrical conduction of two conductors in a spaced/non-contact manner. In an embodiment, the indirect coupling may also be referred to as capacitive coupling. For example, signal transmission is implemented by forming an equivalent capacitor through coupling in a gap between two spaced conductive members.

"At least one of A, B, and C" and "at least one of A, B, or C" have the same meaning, and both include the following combinations of A, B, and C: only A, only B, only C, a combination of A and B, a combination of A and C, a combination of B and C, and a combination of A, B, and C.

"A and/or B" includes the following three combinations: only A, only B, and a combination of A and B.

As used herein, "parallel", "perpendicular to", and "equal to" include described cases and similar cases. A range of this similar case is in an acceptable deviation range. The acceptable deviation range is determined by a person of ordinary skill in the art by considering an error (namely, a limitation of a measurement system) related to measurement being discussed and measurement of a specific quantity. For example, "parallel" includes "absolutely parallel" and "approximately parallel", and an acceptable deviation range of "approximately parallel" may be, for example, a deviation within 5°. "Perpendicular to" includes "absolutely perpendicular to" and "approximately perpendicular to", and an acceptable deviation range of "approximately perpendicular to" may also be, for example, a deviation within 5°. "Equal to" includes "absolutely equal to" and "approximately equal to". An acceptable deviation range of "approximately equal to" may be that, for example, a difference between two equal objects is less than or equal to 5% of either of the two objects.

Example implementations are described herein with reference to a sectional view and/or a plane view of the accompanying drawings as idealized example drawings. In the accompanying drawings, for clarity, thicknesses of layers and regions are increased. Thus, a change in a shape in the accompanying drawings due to, for example, manufacturing techniques and/or tolerances may be envisaged. Therefore, example implementations should not be construed as being limited to a shape of a region shown herein, but rather include shape deviations due to, for example, manufacturing. Therefore, the regions shown in the accompanying drawings are essentially examples, and shapes of the regions are not intended to show actual shapes of regions of a device, and are not intended to limit a scope of the example implementations.

In addition, a scenario described in embodiments of this application is intended to describe the technical solutions in embodiments of this application more clearly, but does not constitute a limitation on the technical solutions provided in embodiments of this application. A person of ordinary skill in the art may learn that as a new scenario emerges, the technical solutions provided in embodiments of this application are also applicable to a similar technical problem.

As a mainstream interaction manner, biometric feature identification (for example, fingerprint identification) is widely applied to user identification, unlocking, secure payment, and the like on mobile phones, and has become an indispensable function of modern mobile phones. In addition, in daily home life, including scenarios such as tablets, laptops, and door locks, fingerprint identification is used to confirm a user identity. In addition, a promising application area for fingerprint identification is in intelligent vehicles. For example, a driver may authenticate a user identity through fingerprint identification on a vehicle door handle to unlock a vehicle door, thereby completely eliminating the inconvenience of using a vehicle key. In addition, fingerprint unlocking in the vehicle may also be used for engine ignition. When the driver presses a button to start the vehicle, the vehicle performs authentication through the fingerprint. More conveniently, information of different drivers may be recorded for fingerprint unlocking, and during driving, user preferences of the drivers are recorded. After the vehicle is started, the vehicle authenticates the driver and loads user preferences and cockpit settings (such as seat and rear view mirror settings). This provides an improved user experience for family members. Therefore, a biometric identification technology has great research value.

An embodiment of this application provides an electronic device. The electronic device has a biometric feature detection function for a pressed object, and may detect, for example, a fingerprint, a palmprint, or a handprint. The electronic device is, for example, a consumer electronic product, a home electronic product, or a vehicle-mounted electronic product with a biometric feature detection function. The consumer electronic product is, for example, a mobile phone (mobile phone), a tablet computer (pad), a notebook computer, an e-reader, a personal computer (personal computer, PC), a personal digital assistant (personal digital assistant, PDA), a desktop display, a game device, a smart wearable product (for example, a smart watch, a smart band, or smart jewelry), a virtual reality (virtual reality, VR) terminal device, an augmented reality (augmented reality, AR) terminal device, an uncrewed aerial vehicle, an electronic database, or an automated teller machine. The home electronic product is, for example, a smart door lock, a television, a remote control, a refrigerator, a small rechargeable household appliance (for example, a soy milk maker or a robot vacuum), or the like. The vehicle-mounted electronic product is, for example, a vehicle-mounted navigator, a vehicle-mounted high-density digital video disc (digital video disc, DVD), a car door handle, or engine ignition. The electronic device may be an electronic device having a display function, or the electronic device may be an electronic device having no display function. This is not limited in embodiments of this application.

The following uses an example in which the electronic device is a mobile phone for description.

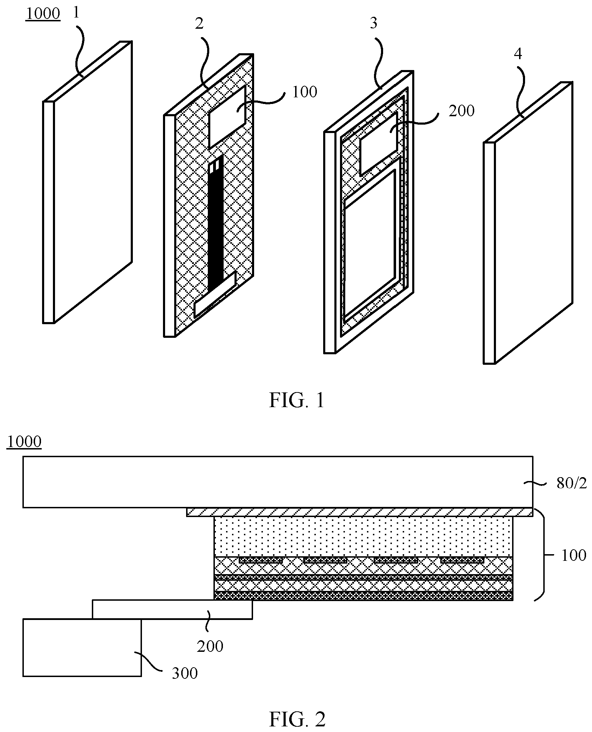

FIG. 1 is a diagram of a structure of an electronic device according to an embodiment of this application. FIG. 2 is a sectional view of an electronic device according to an embodiment of this application.

As shown in FIG. 1, an electronic device 1000 may include a cover plate 1, a display 2, a middle frame 3, and a rear housing 4.

Refer to FIG. 1. The rear housing 4 and the display 2 are respectively located on two sides of the middle frame 3, the middle frame 3 and the display 2 are disposed in the rear housing 4, the cover plate 1 is disposed on a side of the display 2 that faces away from the middle frame 3, and a display surface of the display 2 faces the cover plate 1.

For example, the display 2 may be a low-temperature poly-silicon (low temperature poly-silicon, LTPS) display, an active-matrix organic light emitting diode (active-matrix organic light emitting diode, AMOLED) display, a low-temperature polycrystalline oxide (low temperature polycrystalline oxide, LTPO) display, a liquid crystal display (liquid crystal display, LCD), or a micro organic light emitting diode (micro light emitting diode, micro LED) display. Certainly, a type of the display 2 is not limited in this embodiment of this application. All displays having a display function are applicable to this embodiment of this application. The foregoing examples are merely examples.

On this basis, as shown in FIG. 1 and FIG. 2, the electronic device 1000 further includes an ultrasonic sensor 100.

For example, the ultrasonic sensor 100 may be an ultrasonic fingerprint identification sensor. Refer to FIG. 2. The ultrasonic sensor 100 is disposed on one side of the display 2. The ultrasonic sensor 100 is configured to provide a biometric feature identification function for the electronic device 1000.

In addition, a person skilled in the art may understand that the structure of the electronic device 1000 shown in the foregoing accompanying drawings does not constitute a limitation on the electronic device 1000. The electronic device 1000 may include more or fewer components than those shown in the figure, may combine some components, or may have different component arrangements.

For example, refer to FIG. 1 and FIG. 2. The electronic device 1000 may further include a circuit board 200. Refer to FIG. 2. The circuit board 200 is coupled to the ultrasonic sensor 100. For example, the circuit board 200 and the ultrasonic sensor 100 are directly electrically connected, or the circuit board 200 and the ultrasonic sensor 100 may be indirectly coupled.

The circuit board 200 may be a printed circuit board (printed circuit board, PCB). Certainly, the circuit board 200 may alternatively be a flexible circuit board, a rigid-flexible circuit board, or the like. Optionally, the circuit board 200 may be fastened between the middle frame 3 and the rear housing 4 in a manner of threaded connection, clamping, adhesive bonding, or the like.

Alternatively, for example, the electronic device 1000 may further include a plurality of peripheral components. Refer to FIG. 2. The peripheral component may be a control chip 300. For example, the control chip 300 may be electrically connected to the ultrasonic sensor 100 through the circuit board 200. The control chip 300 may control the ultrasonic sensor 100 to analyze and identify a to-be-detected object (for example, a fingerprint), and the like.

Alternatively, for example, the electronic device 1000 may further include components such as a battery, a camera, a microphone, a speaker, a radio frequency circuit, an input unit, a sensor, an audio circuit, a wireless fidelity (wireless fidelity, Wi-Fi) module, a power supply, and a Bluetooth module. Details are not described herein.

Biometric identification technologies have been widely applied to people's daily life. Due to features of human body fingerprints and palmprint information, for example, uniqueness, difficulty to obtain, and convenience of use, the biometric identification technologies have become one of mainstream identification technologies in fields such as consumer electronics, smart home, and industries. Currently, main fingerprint identification technologies in the market mainly include a capacitive fingerprint identification technology, an optical fingerprint identification technology, and an ultrasonic fingerprint identification technology.

The ultrasonic fingerprint identification technology is a security authentication technology in which an ultrasonic wave is emitted under a screen (for example, the display 2), penetrates screen stacked layers, detects fingerprint information on an upper surface of the screen, and then transmits the fingerprint information back to an original position to reproduce the fingerprint information. Due to features such as a fast unlocking speed, a wide range of applicable scenarios, and a 3D anti-counterfeiting function, the ultrasonic fingerprint identification technology gradually becomes a mainstream technology in the biometric identification technologies.

However, with the development of screens, screens produced by different manufacturers exhibit different acoustic performance. Some screens have higher acoustic transmittance, whereas some screens have lower acoustic transmittance. Therefore, the performance of ultrasonic fingerprint identification sensors needs to be further improved to meet requirements of more screen types. In addition, many users habitually attach tempered glass screen protectors or privacy screen protectors. These additional films attenuate ultrasonic signals, which reduces fingerprint contrast in the ultrasonic fingerprint identification sensor and affects the identification performance. In addition, with the rise of foldable screens, a metal support layer in a foldable screen may also severely attenuate ultrasonic signals. The development of COE screens may also affect identification performance of the ultrasonic fingerprint identification sensor. Therefore, how to further improve the identification capability of the ultrasonic fingerprint identification sensor becomes a problem to be resolved in the current biometric identification technology.

To resolve the foregoing technical problem, an embodiment of this application provides an ultrasonic sensor 100.

For example, the ultrasonic sensor 100 may use an ultrasonic in-screen fingerprint identification technology.

For example, the ultrasonic sensor 100 may be used as an independent component, or may be used in the electronic device 1000.

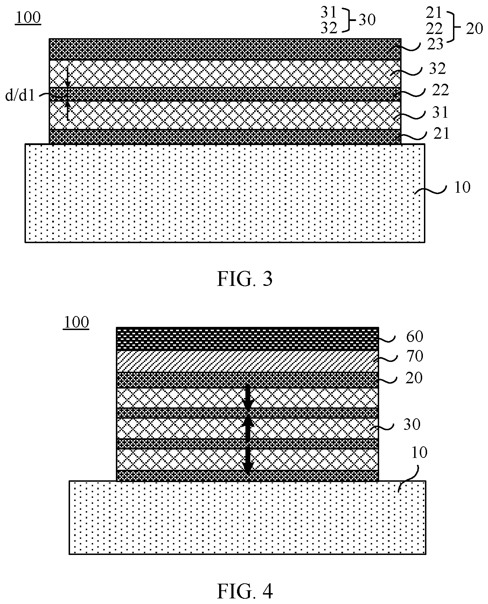

FIG. 3 and FIG. 4 are diagrams of a structure of the ultrasonic sensor 100 according to an embodiment of this application.

As shown in FIG. 3 and FIG. 4, the ultrasonic sensor 100 includes a substrate 10, a plurality of electrode layers 20, and a plurality of piezoelectric layers 30.

The substrate 10 is configured to serve as a bearing plate, and provide support and bearing functions in a process of manufacturing the electrode layers 20 and the piezoelectric layers 30, to avoid defects such as breakage, cracking, or depression of the electrode layers 20 or the piezoelectric layers 30.

For example, a material of the substrate 10 includes a polymer material such as glass, a silicon wafer, polyimide (polyimide, PI), or polyethylene terephthalate (polyethylene terephthalate, PET). For example, the substrate 10 may be a glass substrate.

The electrode layer 20 is configured to load an electrical signal (for example, load a high voltage pulse signal or a fixed level), so that an electric potential difference can be formed on two side surfaces of the piezoelectric layer 30 in contact with the electrode layer 20, thereby facilitating the piezoelectric layer 30 to transform into high frequency mechanical vibration under an action of converse piezoelectric effect, that is, to emit an ultrasonic wave. In addition, the electrode layer 20 is further configured to transmit an electrical signal generated by the piezoelectric layer 30 in response to the ultrasonic wave.

For example, a material of the electrode layer 20 may be a transparent conductive material or a non-transparent conductive material. For example, the material of the electrode layer 20 may include at least one of metal materials such as aluminum (Al), copper (Cu), gold (Au), and platinum (Pt), may include inorganic conductive materials such as indium tin oxide (Indium tin oxide, ITO), may include organic conductive materials such as PEDOT:PSS and graphite, or may be a composite conductive material of metal and inorganic or organic materials, for example, a composite material of silver paste and anisotropic conductive film (anisotropic conductive film, ACF).

The piezoelectric layer 30 is configured to generate an ultrasonic signal (that is, an ultrasonic wave) under excitation of an alternating current signal, and is configured to receive an ultrasonic signal and convert the ultrasonic signal into an electrical signal.

For example, a material of the piezoelectric layer 30 has piezoelectricity. For example, the material of the piezoelectric layer 30 may include an organic piezoelectric material, for example, at least one of polyvinylidene fluoride (polyvinylidene fluoride, PVDF), polyvinylidene fluoride-trifluoroethylene (polyvinylidene fluoride-trifluoroethylene, PVDF-TrFE), polyvinylidene fluoride-trifluoroethylene-chlorofluoroethylene (polyvinylidene fluoride-trifluoroethylene-chlorofluoroethylene, PVDF-TrFE-CFE), and a composite thereof.

An operating process of the ultrasonic sensor 100 is divided into a transmitting (transmitter, TX) phase and a receiving (receiver, RX) phase. In the transmitting phase, for example, a high voltage pulse signal with a voltage greater than 100 V and a frequency in a range of 5 MHz to 20 MHz may be output to the ultrasonic sensor 100 through an external circuit, and the high voltage pulse signal is transmitted to an electrode layer 20 located on one side of the piezoelectric layer 30. In addition, a fixed level is loaded to an electrode layer 20 located on the other side of the piezoelectric layer 30, so that an electrostatic high voltage can be formed on the two sides of the piezoelectric layer 30. The piezoelectric layer 30 generates high frequency mechanical vibration under the action of the voltage through converse piezoelectric effect, that is, generates an ultrasonic wave. After the ultrasonic wave passes through each layer of medium and is transmitted to a to-be-detected object (for example, a finger), a part of the ultrasonic wave is reflected by the to-be-detected object. In the receiving phase, the reflected ultrasonic wave passes through each layer of medium again and reaches the piezoelectric layer 30. The static piezoelectric layer 30 that is almost stationary is excited by the reflected ultrasonic wave to generate deformation, and the deformation is then converted into a high frequency pulse electrical signal. The electrical signal is received through the electrode layer 20, and related information (for example, fingerprint comparison information) of the to-be-detected object may be obtained by analyzing the electrical signal.

As shown in FIG. 3 and FIG. 4, in this embodiment of this application, the ultrasonic sensor 100 includes the plurality of electrode layers 20 and the plurality of piezoelectric layers 30 that are disposed on the same side of the substrate 10, and the electrode layers 20 and the piezoelectric layers 30 are alternately stacked.

For example, refer to FIG. 3. The ultrasonic sensor 100 may include three electrode layers 20, which are respectively a first electrode layer 21, a second electrode layer 22, and a third electrode layer 23 in a direction away from the substrate 10. The ultrasonic sensor 100 may include two piezoelectric layers 30, which are respectively a first piezoelectric layer 31 and a second piezoelectric layer 32 in the direction away from the substrate 10. The first piezoelectric layer 31 is disposed between the first electrode layer 21 and the second electrode layer 22, and the second piezoelectric layer 32 is disposed between the second electrode layer 22 and the third electrode layer 23.

Alternatively, for example, refer to FIG. 4. The ultrasonic sensor 100 may include three or more piezoelectric layers 30. For example, in FIG. 4, an example in which the ultrasonic sensor 100 includes three piezoelectric layers 30 and four electrode layers 20 is used to illustrate a structure of the ultrasonic sensor 100.

For example, the signal loaded by the electrode layer 20 may be an alternating current signal, for example, may be a sine wave signal, a square wave signal, or a pulse signal.

It may be understood that there is a potential difference between electrical signals transmitted by two adjacent electrode layers 20, so that a piezoelectric layer 30 disposed between the two adjacent electrode layers 20 is in an alternating current field, to enable the piezoelectric layer 30 to generate an ultrasonic wave.

For example, the first electrode layer 21 and the third electrode layer 23 may be loaded with high voltage pulse signals, and the second electrode layer 22 may be loaded with a low voltage signal, so that both the first piezoelectric layer 31 and the second piezoelectric layer 32 are in an alternating current field.

For example, at a same moment, directions of electric fields in which the two adjacent piezoelectric layers 30 are located may be opposite. For example, refer to the structure in FIG. 3. The first electrode layer 21 and the third electrode layer 23 may transmit completely same electrical signals, and the second electrode layer 22 may transmit an electrical signal different from an electrical signal of the first electrode layer 21 and an electrical signal of the third electrode layer 23. In this case, at a same moment, directions of electric fields formed by the first electrode layer 21 and the second electrode layer 22 are opposite to directions of electric fields formed by the third electrode layer 23 and the second electrode layer 22.

In this embodiment, at a same moment, a design in which directions of electric fields in which the two adjacent piezoelectric layers 30 are located are different may simplify a connection manner of the electrode layers 20. For example, two electrode layers 20 (for example, the first electrode layer 21 and the third electrode layer 23) that are spaced may transmit same electrical signals. For example, the two electrode layers 20 may be electrically connected, and there is no need to additionally design a plurality of different connection manners (for example, a design in which the first electrode layer 21 and the third electrode layer 23 are respectively connected to different electrical signals).

For example, polarization directions of the two adjacent piezoelectric layers 30 are opposite to each other. When directions of electric fields in which the two adjacent piezoelectric layers 30 are located at a same moment are opposite to each other, the polarization directions of the two adjacent piezoelectric layers 30 are opposite to each other. In this way, ultrasonic waves generated by the two piezoelectric layers 30 at the same moment are transmitted in approximately the same direction, thereby facilitating effective superposition of the ultrasonic waves generated by the two piezoelectric layers 30.

For example, refer to FIG. 4. In the two adjacent piezoelectric layers 30, a polarization direction of one piezoelectric layer 30 (which is illustrated by using an arrow in FIG. 4) may be a direction in which the piezoelectric layer 30 points to the substrate 10 (for example, from top to bottom in FIG. 4), and a polarization direction of the other piezoelectric layer 30 may be a direction in which the piezoelectric layer 30 faces away from the substrate 10 (for example, from bottom to top in FIG. 4).

Polarization means that a polarization voltage is applied to the piezoelectric layer 30, so that grain electric domains in the piezoelectric layer 30 are arranged in an orderly manner, and polarity is externally presented, so that the piezoelectric layer 30 has piezoelectric effect. A polarization direction is a direction of grain electric domain arrangement.

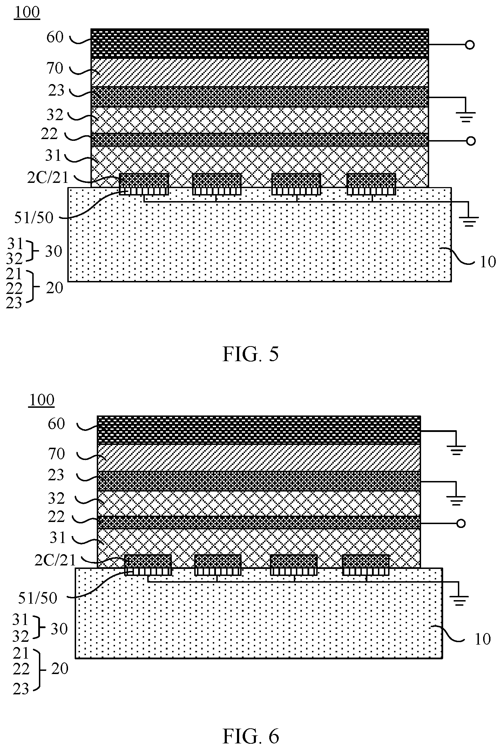

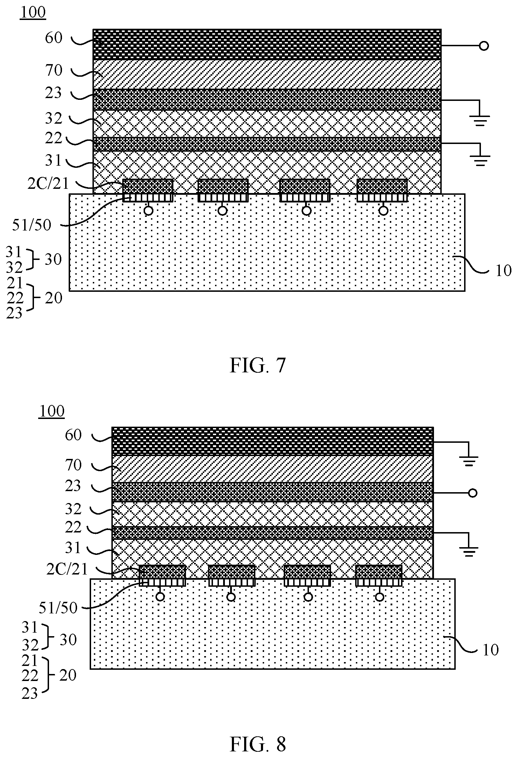

FIG. 5 and FIG. 6 show signal connection manners of the ultrasonic sensor 100 in a transmission process according to an embodiment of this application. FIG. 7 and FIG. 8 show signal connection manners of the ultrasonic sensor 100 in a receiving phase according to an embodiment of this application.

An operating process of the ultrasonic sensor 100 provided in this embodiment of this application may be as follows.

A transmitting phase is as follows.

Refer to FIG. 5 and FIG. 6. A first excitation voltage is loaded on the first electrode layer 21 and the third electrode layer 23, and a second excitation voltage is loaded on the second electrode layer 22. The first excitation voltage and the second excitation voltage are high and low voltages relative to each other, so that the first piezoelectric layer 31 emits a first ultrasonic wave under excitation of a first electric field formed by the first excitation voltage and the second excitation voltage on two sides of the first piezoelectric layer 31, and the second piezoelectric layer 32 emits a second ultrasonic wave under excitation of a second electric field formed by the second excitation voltage and the first excitation voltage on two sides of the second piezoelectric layer 32.

A direction of the first electric field applied to the first piezoelectric layer 31 is opposite to a direction of the second electric field applied to the second piezoelectric layer 32, and polarization directions of the first piezoelectric layer 31 and the second piezoelectric layer 32 are opposite to each other. Therefore, the first ultrasonic wave emitted by the first piezoelectric layer 31 and the second ultrasonic wave emitted by the second piezoelectric layer 32 can be effectively superimposed, thereby effectively enhancing intensity of the emitted ultrasonic wave. Stronger intensity of the emitted ultrasonic wave indicates stronger intensity of a subsequently reflected ultrasonic wave (echo), thereby optimizing an echo signal.

A receiving phase is as follows.

After the emitted ultrasonic wave is emitted, the ultrasonic wave is reflected by a to-be-detected object (for example, a finger), and at least a part of the emitted ultrasonic wave is reflected back to the inside of the ultrasonic sensor 100. The first piezoelectric layer 31 is deformed due to excitation of the reflected ultrasonic wave, and converts deformation into an electrical signal, to detect the to-be-detected object. In this process, refer to FIG. 7 and FIG. 8. The first electrode layer 21 is configured to transmit the electrical signal converted by the first piezoelectric layer 31, to read and process the electrical signal. The second electrode layer 22 may maintain a fixed level or be grounded. The third electrode layer 23 may maintain a fixed level, may be grounded, or may be in a floating state.

It can be learned that, in this embodiment of this application, the plurality of electrode layers 20 and the plurality of piezoelectric layers 30 are disposed, so that a transmitted ultrasonic wave and an echo signal can be effectively enhanced, thereby improving performance of the ultrasonic sensor 100.

In this embodiment, an example in which the ultrasonic sensor 100 includes three electrode layers 20 and two piezoelectric layers 30 is used to illustrate the operating process of the ultrasonic sensor 100.

It may be understood that, similar to a case in which the ultrasonic sensor 100 includes the two piezoelectric layers 30, in this embodiment of this application, the ultrasonic sensor 100 including three or more piezoelectric layers 30 may also implement superposition of ultrasonic waves generated by the plurality of piezoelectric layers 30 in the ultrasonic sensor 100, thereby further improving performance of the ultrasonic sensor 100.

It should be noted that, in the foregoing embodiment of this application, the structure of the ultrasonic sensor 100 is described by using only an example in which the ultrasonic sensor 100 includes the three electrode layers 20 and the two piezoelectric layers 30. This does not constitute a limitation on a quantity of electrode layers 20 or a quantity of piezoelectric layers 30. For example, refer to FIG. 4. The ultrasonic sensor 100 may further include three piezoelectric layers 30 and four electrode layers 20. It may be understood that any quantity of electrode layers 20 and piezoelectric layers 30 that can implement superposition of ultrasonic waves falls within the protection scope of embodiments of this application. This is not limited in embodiments of this application.

In the ultrasonic sensor 100 provided in embodiments of this application, Curie temperatures of the piezoelectric layers 30 gradually decrease in the direction away from the substrate 10.

For example, when the ultrasonic sensor 100 includes the first piezoelectric layer 31 and the second piezoelectric layer 32, a Curie temperature of the second piezoelectric layer 32 is less than a Curie temperature of the first piezoelectric layer 31.

The Curie temperature of the piezoelectric layer 30 means that when a temperature of the piezoelectric material reaches a specific value, piezoelectric effect of a piezoelectric material automatically disappears (depolarization), and the temperature value is the Curie temperature of the piezoelectric layer 30.

In the piezoelectric material, the Curie temperature is an important parameter, which determines piezoelectric performance of the piezoelectric materials at different temperatures. Different piezoelectric materials may correspond to different Curie temperatures. For example, the Curie temperatures of different piezoelectric layers 30 may be adjusted by adjusting material formulations of the different piezoelectric layers 30.

In a fabrication process of the ultrasonic sensor 100, high temperature annealing and crystallization need to be performed on the piezoelectric layer 30, so that the piezoelectric layer 30 forms a complete molecular chain, and then a polarization operation is performed to enable the piezoelectric layer 30 to have piezoelectric effect.

Polarization means that a polarization voltage is applied to the piezoelectric layer 30, so that grain electric domains in the piezoelectric layer 30 are arranged in an orderly manner, and polarity is externally presented, so that the piezoelectric layer 30 has piezoelectric effect.

An annealing temperature of the piezoelectric layer 30 is higher than the Curie temperature of the piezoelectric layer 30. For example, when the material of the piezoelectric layer 30 includes an organic piezoelectric material, the annealing temperature of the organic piezoelectric material is higher than the Curie temperature of the organic piezoelectric material.

When the plurality of piezoelectric layers 30 are fabricated, if the Curie temperatures of the plurality of piezoelectric layers 30 are the same, an annealing temperature of a piezoelectric layer 30 fabricated later (for example, the second piezoelectric layer 32 in FIG. 3) is necessarily greater than a Curie temperature of a piezoelectric layer 30 fabricated earlier (for example, the first piezoelectric layer 31 in FIG. 3). Consequently, the piezoelectric layer 30 that is fabricated earlier and has undergone polarization is prone to depolarization, which severely affects piezoelectric performance of the piezoelectric layer 30 fabricated earlier.

In the ultrasonic sensor 100 provided in this embodiment of this application, the Curie temperature of the plurality of piezoelectric layers 30 is set to gradually decrease in a direction away from the substrate 10, so that the plurality of piezoelectric layers 30 exhibit a gradient in the Curie temperatures. This allows the annealing temperature of the piezoelectric layer 30 fabricated later to be set between the Curie temperature of the piezoelectric layer 30 fabricated earlier and the Curie temperature of the piezoelectric layer 30 fabricated later, to prevent the piezoelectric layer 30 fabricated earlier from undergoing depolarization during annealing of the piezoelectric layer 30 fabricated later. In this way, it is ensured that each piezoelectric layer 30 has a high degree of polarization, and it is ensured that the piezoelectric layer 30 has good piezoelectric effect during operation of the ultrasonic sensor 100. For example, intensity of an ultrasonic wave generated by the piezoelectric layer 30 can be increased, thereby improving performance of the ultrasonic sensor 100.

For example, a difference between Curie temperatures of two adjacent piezoelectric layers 30 is 5°C to 20°C. For example, the Curie temperature of the second piezoelectric layer 32 is 5°C to 20°C lower than the Curie temperature of the first piezoelectric layer 31. For example, the Curie temperature of the second piezoelectric layer 32 is 5°C, 9.8°C, 13.87°C, 18.358°C, or 20°C lower than the Curie temperature of the first piezoelectric layer 31.

In other words, an optional annealing temperature of the piezoelectric layer 30 fabricated later may be 5°C to 20°C greater than the Curie temperature of the piezoelectric layer 30. On one hand, this can ensure that sufficient annealing is performed on the piezoelectric layer 30, thereby ensuring a polarization degree of the piezoelectric layer 30. On the other hand, this ensures that the piezoelectric layer 30 fabricated later does not cause depolarization of the piezoelectric layer 30 fabricated earlier in a high temperature annealing process, thereby ensuring that all piezoelectric layers 30 have good piezoelectric effect.

For example, an annealing temperature of a piezoelectric layer 30 farther away from the substrate 10 is less than a Curie temperature of a piezoelectric layer 30 closer to the substrate 10.

For example, refer to FIG. 3. When the ultrasonic sensor 100 includes the first piezoelectric layer 31 and the second piezoelectric layer 32, an annealing temperature of the second piezoelectric layer 32 is less than the Curie temperature of the first piezoelectric layer 31. Therefore, a problem that the first piezoelectric layer 31 loses the piezoelectric effect in the annealing process of the second piezoelectric layer 32 is avoided.

In addition to the foregoing embodiment in which performance of the ultrasonic sensor 100 is improved by controlling the Curie temperature of the piezoelectric layer 30, performance of the ultrasonic sensor 100 may be further improved by using the following embodiment.

In some embodiments, the electrode layer 20 located between two adjacent piezoelectric layers 30 is a preset electrode layer (for example, the second electrode layer 22 in FIG. 3), and a thickness d1 of the preset electrode layer is less than or equal to 0.1λ₁. For example, the thickness d1 of the preset electrode layer may be 0.1λ₁, 0.05λ₁, 0.0135λ₁, or the like.

λ₁ is a wavelength of a sound wave passing through the preset electrode layer. The wavelength of the sound wave passing through the preset electrode layer is ${λ}_{1} = \frac{{C}_{1}}{{f}_{1}}$, where C₁ is a wave speed of the sound wave passing through the preset electrode layer, the wave speed is related to a material of the preset electrode layer, and f₁ is an operating frequency of the ultrasonic sensor 100.

In other words, in the plurality of electrode layers 20, the thickness d1 of the electrode layer 20 located in the middle film layer is approximately one tenth of the wavelength of the sound wave passing through the electrode layer 20, so that an acoustic transparent layer is formed. In this way, a sound wave generated by the piezoelectric layer 30 or a sound wave reflected by a to-be-detected object can almost pass through the preset electrode layer without loss, thereby avoiding increasing a loss during sound wave transmission by the preset electrode layer located between the two piezoelectric layers 30, and further improving performance of the ultrasonic sensor 100.

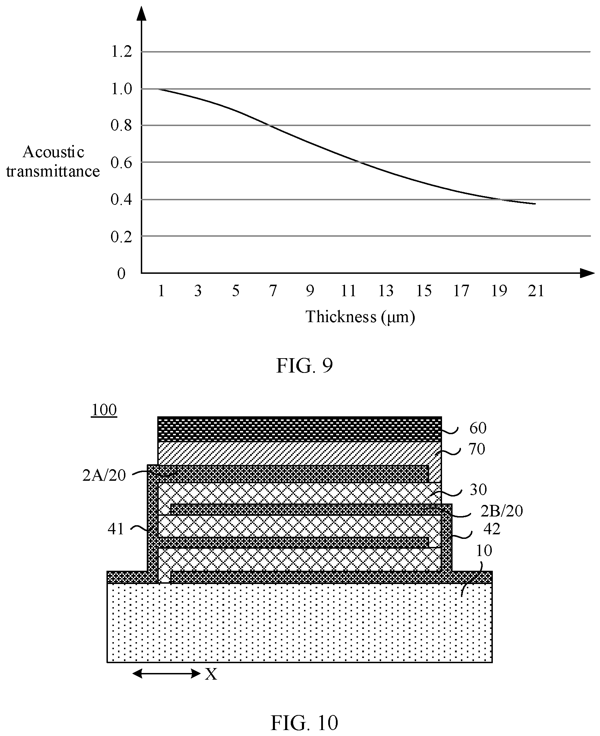

FIG. 9 is a thickness-acoustic transmittance relationship diagram of the second electrode layer 22 (that is, the preset electrode layer) in FIG. 3.

As shown in FIG. 9, when the thickness of the second electrode layer 22 is large, the acoustic transmittance of the second electrode layer 22 is significantly reduced. When the thickness of the second electrode layer 22 is less than or equal to one tenth of the wavelength (the wavelength of a sound wave passing through the second electrode layer 22), for example, in FIG. 9, when the thickness is 5 µm, an acoustic transmittance of the second electrode layer 22 may be approximately 90%. In other words, the sound wave can almost pass through the second electrode layer 22 without loss, thereby effectively improving performance of the ultrasonic sensor 100.

In some embodiments, in the plurality of electrode layers 20, the thickness d of each electrode layer 20 (refer to FIG. 3) is less than or equal to 0.1λ. For example, the thickness d of the electrode layer 20 may be 0.1λ, 0.0789λ, 0.05λ, 0.012λ, or the like.

λ is the wavelength of the sound wave passing through the electrode layer 20. The wavelength of a sound wave passing through the electrode layer is $λ = \frac{C}{f}$, where C is a wave speed of the sound wave passing through the electrode layer 20, the wave speed is related to a material of the electrode layer 20, and f is an operating frequency of the ultrasonic sensor 100.

In other words, in the plurality of electrode layers 20, the thickness d of each electrode layer 20 (referring to FIG. 3) is one tenth of the wavelength of the sound wave passing through the electrode layer 20, so that the sound wave generated by the piezoelectric layer 30 or the sound wave reflected by the to-be-detected object can almost pass through all the electrode layers 20 without loss, thereby further reducing a loss during sound wave transmission in the ultrasonic sensor 100, and further improving performance of the ultrasonic sensor 100.

In some embodiments, a sum of a thickness-to-wavelength ratio of the plurality of piezoelectric layers 30 and a thickness-to-wavelength ratio of the plurality of electrode layers 20 is 0.15N to 0.35N.

Herein, N is an odd number. For example, N may be 1, 3, 5, 7, or the like.

In other words, from an electrode layer 20 closest to the substrate 10 to an electrode layer 20 farthest from the substrate 10, a sum of thickness-to-wavelength ratios of all the film layers is 0.15N to 0.35N.

For example, refer to FIG. 3. A sum of thickness-to-wavelength ratios of the first electrode layer 21, the first piezoelectric layer 31, the second electrode layer 22, the second piezoelectric layer 32, and the third electrode layer 23 is 0.15N to 0.35N.

For example, the sum of the thickness-to-wavelength ratio of the plurality of piezoelectric layers 30 and the thickness-to-wavelength ratio of the plurality of electrode layers 20 may be 0.15N, 0.2N, 0.275N, or 0.35N. For example, the sum of the thickness-to-wavelength ratio of the plurality of piezoelectric layers 30 and the thickness-to-wavelength ratio of the plurality of electrode layers 20 may be 0.25N.

The thickness-to-wavelength ratio is a ratio of a thickness of a film layer to a length of an acoustic wave passing through the film layer. For example, a wavelength of each electrode layer 20 is $λ = \frac{C}{f}$, and a thickness-to-wavelength ratio of a single electrode layer 20 is $\frac{d}{λ}$, λwhere C is a wave speed of an acoustic wave passing through the electrode layer 20, the wave speed is related to a material of the electrode layer 20, f is an operating frequency of the ultrasonic sensor 100, and d is a thickness of the electrode layer 20. The same applies to the piezoelectric layer 30.

The sum of the thickness-to-wavelength ratio of the plurality of piezoelectric layers 30 and the thickness-to-wavelength ratio of the plurality of electrode layers are set 20 to 0.15N to 0.35N, so that it is convenient for the thickness of the structure of the ultrasonic sensor 100 located on one side of the substrate 10 to form a resonator approximating an odd multiple of a quarter wavelength, thereby facilitating effective superposition of ultrasonic waves emitted by different piezoelectric layers 30, and enhancing the sound pressure emission intensity of the ultrasonic sensor 100. In addition, an overall thickness of the ultrasonic sensor 100 can be controlled to be within a relatively small range, thereby reducing attenuation of ultrasonic waves in each film layer and further improving performance of the ultrasonic sensor 100.

In some embodiments, a sum of the thickness-to-wavelength ratio of the substrate 10, the thickness-to-wavelength ratio of the plurality of piezoelectric layers 30, and the thickness-to-wavelength ratio of the plurality of electrode layers 20 is approximately 0.35M to 0.65M, for example, 0.35M, 0.5M, 0.623M, or 0.65M.

M is an integer. For example, M may be an integer such as 1, 2, 3, or 4.

In other words, a thickness of an overall structure of the ultrasonic sensor 100 forms a resonant body that is close to an integer multiple of a half wavelength, which further facilitates superposition of ultrasonic waves, thereby enhancing resonance effect, and enhancing electrical performance of the ultrasonic sensor 100.

The structure in FIG. 3 is used as an example. If a thickness and a wavelength of the substrate 10 are respectively dₐ and λₐ, a thickness-to-wavelength ratio of the substrate 10 is ${R}_{a} = \frac{{d}_{a}}{{λ}_{a}}$. Similarly, if a thickness and a wavelength of the first electrode layer 21 are respectively d₁ and λ₁, a thickness-to-wavelength ratio of the first electrode layer 21 is ${R}_{1} = \frac{{d}_{1}}{{λ}_{1}}$. If a thickness and a wavelength of the first piezoelectric layer 31 are respectively d₂ and λ₂, a thickness-to-wavelength ratio of the first piezoelectric layer 31 is ${R}_{2} = \frac{{d}_{2}}{{λ}_{2}}$. If a thickness and a wavelength of the second electrode layer 22 are respectively d₃ and λ₃, a thickness-to-wavelength ratio of the second electrode layer 22 is ${R}_{3} = \frac{{d}_{3}}{{λ}_{3}}$. If a thickness and a wavelength of the second piezoelectric layer 32 are respectively d₄ and λ₄, a thickness-to-wavelength ratio of the second piezoelectric layer 32 is ${R}_{4} = \frac{{d}_{4}}{{λ}_{4}}$. If a thickness and a wavelength of the third electrode layer 23 are respectively d₅ and λ₅, a thickness-to-wavelength ratio of the third electrode layer 23 is ${R}_{5} = \frac{{d}_{5}}{{λ}_{5}}$. In this case, a sum of the thickness-to-wavelength ratio of the substrate 10, the thickness-to-wavelength ratio of the plurality of piezoelectric layers 30, and the thickness-to-wavelength ratio of the plurality of electrode layers 20 is $R = {R}_{a} + {R}_{1} + {R}_{2} + {R}_{3} + {R}_{4} + {R}_{5} = \frac{{d}_{a}}{{λ}_{a}} + \frac{{d}_{1}}{{λ}_{1}} + \frac{{d}_{2}}{{λ}_{2}} + \frac{{d}_{3}}{{λ}_{3}} + \frac{{d}_{4}}{{λ}_{4}} + \frac{{d}_{5}}{{λ}_{5}}$. A value of R is approximately 0.5M.

FIG. 10 is another diagram of a structure of an ultrasonic sensor 100 according to an embodiment of this application.

In some embodiments, refer to FIG. 10. In the plurality of electrode layers 20, two electrode layers 20 that are spaced are electrically connected, and one electrode layer 20 is disposed between the two electrode layers 20 that are electrically connected.

In other words, the two adjacent electrode layers 20 are insulated from each other, so that the two adjacent electrode layers 20 can respectively transmit different electrical signals, so that electric potential can be formed on two sides (for example, an upper side and a lower side in FIG. 10) of the piezoelectric layer 30 that is disposed between the two adjacent electrode layers 20, thereby facilitating the piezoelectric layer 30 to generate an ultrasonic wave.

For example, refer to FIG. 10. The ultrasonic sensor 100 includes four electrode layers 20, which are respectively two first sublayers 2A and two second sublayers 2B, and the first sublayer 2A and the second sublayer 2B are alternately stacked. The two first sublayers 2A are electrically connected, and the two second sublayers 2B are electrically connected, so that all the first sublayers 2A transmit a first signal (for example, a first excitation voltage), and all the second sublayers 2B transmit a second signal (for example, a second excitation voltage), so that an electric potential difference is formed on upper and lower sides of all the piezoelectric layers 30.

For example, refer to FIG. 10. The ultrasonic sensor 100 further includes a first side edge trace 41 and a second side edge trace 42. The first side edge trace 41 and the second side edge trace 42 are respectively disposed on two sides of the plurality of electrode layers 20 in a first direction X. The first direction X is parallel to the substrate 10.

For example, refer to FIG. 10. The first side edge trace 41 and the second side edge trace 42 are respectively disposed on the left side and the right side of the plurality of electrode layers 20 in the first direction X.

The two adjacent first sublayers 2A are electrically connected through the first side edge trace 41, and the two adjacent second sublayers 2B are electrically connected through the second side edge trace 42.

Refer to FIG. 10. The first side edge trace 41 is insulated from the second sublayer 2B, and the second side edge trace is insulated from the first sublayer 2A.

For example, refer to FIG. 10. Insulation is implemented between the first side edge trace 41 and the second sublayer 2B by using a part of the piezoelectric layer 30, and insulation is implemented between the second side edge trace and the first sublayer 2A by using a part of the piezoelectric layer 30.

For example, refer to FIG. 10. The first side edge trace 41 further includes a part located on the substrate 10. The part may be used as a first signal input port, and the first signal input port is configured to be electrically connected to an external circuit (for example, the control chip 300 in FIG. 2), to transmit a first signal to the first sublayer 2A connected to the first side edge trace 41.

For example, refer to FIG. 10. The second side edge trace 42 further includes a part located on the substrate 10. The part may be used as a second signal input port, and the second signal input port is configured to be electrically connected to an external circuit (for example, the control chip 300 in FIG. 2), to transmit a second signal to the second sublayer 2B connected to the second side edge trace 42.

In addition to the structures such as the substrate 10, the electrode layer 20, and the piezoelectric layer 30 in the foregoing embodiment, the ultrasonic sensor 100 provided in this embodiment of this application may further include the following structures.

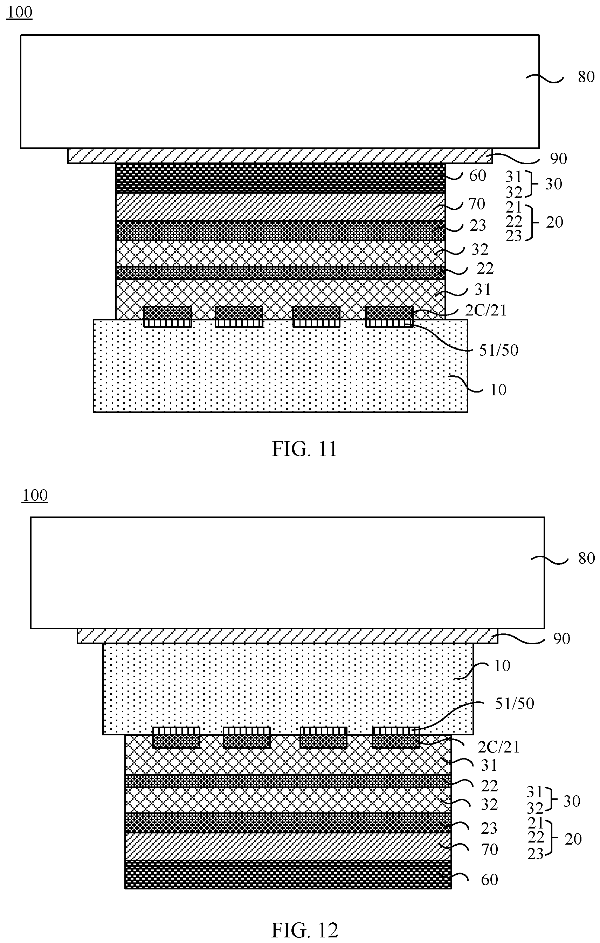

FIG. 11 and FIG. 12 are diagrams of another structure of an ultrasonic sensor 100 according to an embodiment of this application.

In some embodiments, with reference to FIG. 5 to FIG. 8, FIG. 11, and FIG. 12, the ultrasonic sensor 100 further includes a circuit layer 50.

Refer to FIG. 11. The circuit layer 50 is disposed between an electrode layer 20 closest to the substrate 10 and the substrate 10. For example, as shown in FIG. 11, the circuit layer 50 may be embedded in a surface of the substrate 10 that is close to the electrode layer 20.

Refer to FIG. 11 and FIG. 12. The circuit layer 50 includes a plurality of spaced pixel circuits 51. For example, the pixel circuit 51 may be a circuit unit including an analog digital module, and the plurality of pixel circuits 51 may be arranged in an array.

Refer to FIG. 11 and FIG. 12. In the plurality of electrode layers 20, the electrode layer 20 closest to the substrate 10 may include a plurality of spaced electrode blocks 2C. The plurality of electrode blocks 2C are electrically connected to the plurality of pixel circuits 51. For example, the plurality of electrode blocks 2C are coupled to the plurality of pixel circuits 51 in a one-to-one correspondence, and a group of electrode blocks 2C and pixel circuits 51 that are coupled to each other form a pixel unit for fingerprint detection.

The plurality of electrode blocks 2C may transmit an electrical signal (including fingerprint information) generated by the piezoelectric layer 30 in response to an ultrasonic wave reflected by a to-be-detected object. The plurality of electrode blocks 2C discretize the electrical signal, and implement point-column image restoration of the to-be-detected object by using the plurality of pixel circuits 51. For example, fingerprint imaging may be implemented.

For example, refer to FIG. 3, FIG. 4, and FIG. 10. In another embodiment, when the ultrasonic sensor 100 does not need to implement image restoration of the to-be-detected object, the electrode layer 20 closest to the substrate 10 may also be disposed as an entire layer.

In some embodiments, as shown in FIG. 4 to FIG. 8, FIG. 10 to FIG. 12, and the like, the ultrasonic sensor 100 further includes a protective layer 60.

Refer to FIG. 11 and FIG. 12. The protective layer 60 is stacked on a side that is of the electrode layer 20 farthest from the substrate 10 and that faces away from the substrate 10, and the protective layer 60 is insulated from the electrode layer 20.

For example, a material of the protective layer 60 includes a metal material. For example, the material of the protective layer 60 includes aluminum (Al), copper (Cu), or the like.

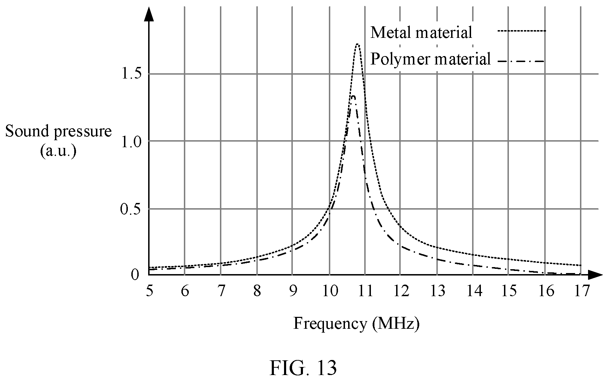

FIG. 13 is a frequency-sound pressure comparison diagram when the electrode layer 20 is of a metal material or a polymer material. As shown in FIG. 13, when the protective layer 60 includes a polymer material, a sound wave undergoes significant attenuation when being transmitted in the ultrasonic sensor 100, which reduces performance of the ultrasonic sensor 100. The material of the protective layer 60 is set to a metal material, so that compared with the polymer material, the same frequency resonance can be implemented by using a smaller thickness, which helps reduce an overall thickness of the ultrasonic sensor 100 and facilitates miniaturization.

The protective layer 60 may provide mechanical support for the ultrasonic sensor 100. By providing the protective layer 60, module strength of the ultrasonic sensor 100 can be enhanced, and the effect is particularly significant when the substrate 10 is a flexible substrate. In addition, simulation shows that providing the protective layer 60 can further enhance a signal-to-noise ratio of the ultrasonic sensor 100 and improve consistency of ultrasonic signals.

For example, refer to FIG. 5 to FIG. 8. The protective layer 60 may be in a grounded state or a floating state. For example, when the protective layer 60 is grounded, the protective layer 60 can provide effective electromagnetic shielding. In a load environment, the ultrasonic sensor 100 may be prevented from being interfered with by external electromagnetic waves, and electromagnetic interference generated by the ultrasonic sensor 100 may also be prevented from affecting external devices.

For example, refer to FIG. 4 to FIG. 8, FIG. 10, FIG. 11, and FIG. 12. The ultrasonic sensor 100 further includes a first bonding layer 70.

Refer to FIG. 11 and FIG. 12. The first bonding layer 70 is disposed between the electrode layer 20 and the protective layer 60. The first bonding layer 70 can protect the electrode layer 20 from damage, and avoid an unexpected electrical connection of the electrode layer 20. In addition, a frequency of the ultrasonic sensor 100 may be adjusted by adjusting a thickness of the first bonding layer 70.

For example, a material of the first bonding layer 70 is an insulating material, for example, may be a material such as a polymer and its polymeric material, may include a polymer such as an optical clear adhesive (optics clarity adhesive, OCA), PI, PET, or polystyrene sulfone terephthalamide fiber (poly styrene-acrylonitrile, PSA), and may further include a compound with filler doping in these polymers.

For example, the material of the first bonding layer 70 is a material whose acoustic impedance is between the electrode layer 20 and the protective layer 60, and forms an acoustic impedance matching layer, which is conducive to efficient acoustic transmission.

For example, from the protective layer 60 to the electrode layer 20 closest to the substrate 10, a sum of thickness-to-wavelength ratios of all film layers is 0.15N to 0.35N, where N is an odd number.

For example, when the ultrasonic sensor 100 includes the protective layer 60 and the first bonding layer 70, a sum of the thickness-to-wavelength ratio of the protective layer 60, the thickness-to-wavelength ratio of the first bonding layer 70, the thickness-to-wavelength ratio of the plurality of piezoelectric layers 30, and the thickness-to-wavelength ratio of the plurality of electrode layers 20 is 0.15N to 0.35N, for example, 0.25N.

In other words, when the ultrasonic sensor 100 includes the protective layer 60 and the first bonding layer 70, thicknesses of all structures of the ultrasonic sensor 100 on the side of the substrate 10 are also formed into a resonator whose thickness is an odd multiple of a quarter wavelength, so that ultrasonic waves emitted by different piezoelectric layers 30 can be effectively superimposed, and sound pressure emission intensity of the ultrasonic sensor 100 can be enhanced.

For example, when the ultrasonic sensor 100 includes the protective layer 60 and the first bonding layer 70, a sum of the thickness-to-wavelength ratio of the substrate 10, the thickness-to-wavelength ratio of the protective layer 60, the thickness-to-wavelength ratio of the first bonding layer 70, the thickness-to-wavelength ratio of the plurality of piezoelectric layers 30, and the thickness-to-wavelength ratio of the plurality of electrode layers 20 is approximately 0.35M to 0.65, for example, 0.35M, 0.5M, 0.623M, or 0.65M.

M is an integer. For example, M may be an integer such as 1, 2, 3, 4, or 5.

In other words, when the ultrasonic sensor 100 includes the protective layer 60 and the first bonding layer 70, the thickness of the entire structure of the ultrasonic sensor 100 is also formed into a resonator whose thickness is an integer multiple of a half wavelength, so that superimposition of ultrasonic waves is further facilitated, resonance effect is enhanced, and electrical performance of the ultrasonic sensor 100 is enhanced.

The structure in FIG. 5 is used as an example. If the thickness and the wavelength of the substrate 10 are respectively dₐ and λₐ, the thickness-to-wavelength ratio of the substrate 10 is ${R}_{a} = \frac{{d}_{a}}{{λ}_{a}}$. If the thickness and the wavelength of the first electrode layer 21 are respectively d₁ and λ₁, the thickness-to-wavelength ratio of the first electrode layer 21 is ${R}_{1} = \frac{{d}_{1}}{{λ}_{1}}$. If the thickness and the wavelength of the first piezoelectric layer 31 are respectively d₂ and λ₂, the thickness-to-wavelength ratio of the first piezoelectric layer 31 is ${R}_{2} = \frac{{d}_{2}}{{λ}_{2}}$. If the thickness and the wavelength of the second electrode layer 22 are respectively d₃ and λ₃, the thickness-to-wavelength ratio of the second electrode layer 22 is ${R}_{3} = \frac{{d}_{3}}{{λ}_{3}}$. If the thickness and the wavelength of the second piezoelectric layer 32 are respectively d₄ and λ₄, the thickness-to-wavelength ratio of the second piezoelectric layer 32 is ${R}_{4} = \frac{{d}_{4}}{{λ}_{4}}$. If the thickness and the wavelength of the third electrode layer 23 are respectively d₅ and λ₅, the thickness-to-wavelength ratio of the third electrode layer 23 is ${R}_{5} = \frac{{d}_{5}}{{λ}_{5}}$. If the thickness and the wavelength of the first bonding layer 70 are respectively d₆ and λ₆, the thickness-to-wavelength ratio of the first bonding layer 70 is ${R}_{6} = \frac{{d}_{6}}{{λ}_{6}}$. If the thickness and the wavelength of the protective layer 60 are respectively d₇ and λ₇, the thickness-to-wavelength ratio of the protective layer 60 is ${R}_{7} = \frac{{d}_{7}}{{λ}_{7}}$. In this case, a sum of the thickness-to-wavelength ratio of the substrate 10, the thickness-to-wavelength ratio of the plurality of piezoelectric layers 30, the thickness-to-wavelength ratio of the plurality of electrode layers 20, the thickness-to-wavelength ratio of the first bonding layer 70, and the thickness-to-wavelength ratio of the protective layer 60 is $R = {R}_{a} + {R}_{1} + {R}_{2} + {R}_{3} + {R}_{4} + {R}_{5} + {R}_{6} + {R}_{7} = \frac{{d}_{a}}{{λ}_{a}} + \frac{{d}_{1}}{{λ}_{1}} + \frac{{d}_{2}}{{λ}_{2}} + \frac{{d}_{3}}{{λ}_{3}} + \frac{{d}_{4}}{{λ}_{4}} + \frac{{d}_{5}}{{λ}_{5}} + \frac{{d}_{6}}{{λ}_{6}} + \frac{{d}_{7}}{{λ}_{7}}$. A value of R is approximately 0.5M.

It should be noted that, when the thickness of the electrode layer 20 is much thinner than a thickness of another layer (for example, the piezoelectric layer 30), for example, the first electrode layer 21 in FIG. 3 is a thin film fabricated through metal deposition or the like, and the thickness of the thin film is at a nanometer level, a thickness-to-wavelength ratio of the electrode layer 20 with a thin thickness may be ignored, and only a sum of thickness-to-wavelength ratios of other film layers needs to be calculated.

In some embodiments, as shown in FIG. 11 and FIG. 12, the ultrasonic sensor 100 further includes a contact layer 80.

In other words, the contact layer 80 is disposed between a core structure such as the electrode layer 20 and the to-be-detected object (for example, a finger), to protect the core structure such as the electrode layer 20. For example, the contact layer 80 may be used for the finger to press or contact, so that the ultrasonic sensor 100 detects a fingerprint of the finger.

For example, refer to FIG. 11. The contact layer 80 is disposed on a side of the substrate 10 that faces away from the protective layer 60, which may be understood as a back attachment or reverse attachment commonly referred to in this field.

For example, refer to FIG. 12. The contact layer 80 is disposed on a side of the protective layer 60 that faces away from the substrate 10, which may be understood as a front attachment commonly referred to in this field.

In some embodiments, refer to FIG. 2. When the ultrasonic sensor 100 is used in the electronic device 1000, the contact layer 80 may be used as the display 2. In this case, the ultrasonic sensor 100 may further implement imaging display of the to-be-detected object through the contact layer 80.

For example, the contact layer 80 may be of a multi-layer composite material such as a rigid display, a flexible display, a curved display, a 2.5D display, or a 3D display.

In some other embodiments, the contact layer 80 is a cover plate.

For example, the contact layer 80 may be a cover plate like a curved cover plate glass, a flat cover plate glass, a metal cover plate, or a glass cover plate polymer region cover.

For example, as shown in FIG. 11 and FIG. 12, the ultrasonic sensor 100 further includes a second bonding layer 90. The second bonding layer 90 is disposed on a side of the contact layer 80 that is close to the substrate 10. In other words, the contact layer 80 may be bonded and fastened to the substrate 10 or the protective layer 60 through the second bonding layer 90.

For example, a material of the second bonding layer 90 may be the same as a material of the first bonding layer 70.

An embodiment of this application further provides a method for fabricating an ultrasonic sensor 100.

The fabrication method may include: forming the plurality of electrode layers 20 and the plurality of piezoelectric layers 30 on a same side of the substrate 10.

The electrode layer 20 and the piezoelectric layer 30 are alternately stacked, and each piezoelectric layer 30 is disposed between two adjacent electrode layers 20.

In other words, the electrode layer 20 and the piezoelectric layer 30 may be alternately stacked on the substrate 10 in sequence, and a last layer of film is the electrode layer 20.

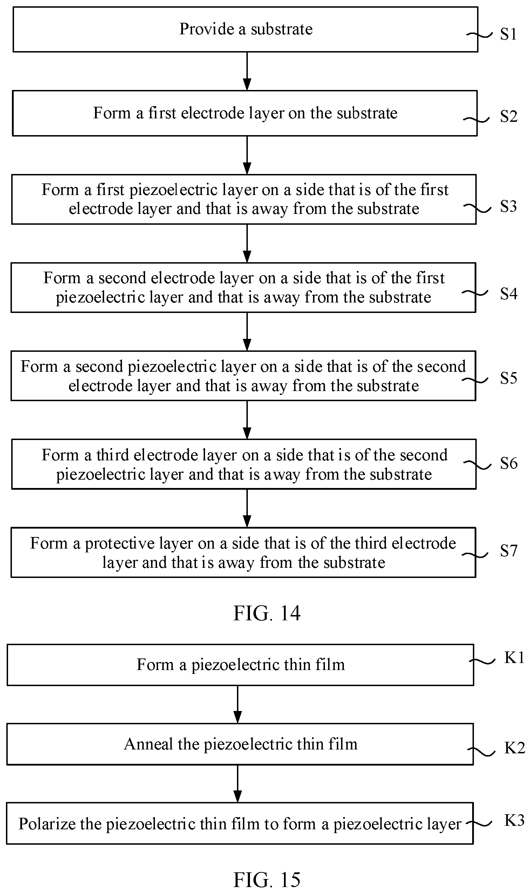

FIG. 14 is a flowchart of fabricating an ultrasonic sensor 100 according to an embodiment of this application.

As shown in FIG. 14, in some embodiments, when the ultrasonic sensor 100 includes three electrode layers 20 (a first electrode layer 21, a second electrode layer 22, and a third electrode layer 23) and two piezoelectric layers 30 (a first piezoelectric layer 31 and a second piezoelectric layer 32), the fabrication method may include the following steps.

S1: Provide a substrate 10.

S2: Form a first electrode layer 21 on the substrate 10.

S3: Form a first piezoelectric layer 31 on a side of the first electrode layer 21 that faces away from the substrate 10.

S4: Form a second electrode layer 22 on a side of the first piezoelectric layer 31 that faces away from the substrate 10.

S5: Form a second piezoelectric layer 32 on a side of the second electrode layer 22 that faces away from the substrate 10.

S6: Form a third electrode layer 23 on a side of the second piezoelectric layer 32 that faces away from the substrate 10.

Curie temperatures of the piezoelectric layers 30 gradually decrease in a direction away from the substrate 10. For example, the first piezoelectric layer 31 has a first Curie temperature, the second piezoelectric layer 32 has a second Curie temperature, and the second Curie temperature is less than the first Curie temperature. This facilitates controlling an annealing temperature of the second piezoelectric layer 32 between the first Curie temperature and the second Curie temperature. In other words, the annealing temperature of the second piezoelectric layer 32 is controlled to be higher than the Curie temperature (the second Curie temperature) of the second piezoelectric layer 32, thereby forming molecular chains and facilitating polarization of the second piezoelectric layer 32. In addition, the annealing temperature of the second piezoelectric layer 32 is controlled to be lower than the Curie temperature (the first Curie temperature) of the first piezoelectric layer 31, thereby preventing the first piezoelectric layer 31 from undergoing depolarization caused by a high temperature in an annealing process of the second piezoelectric layer 32.

For example, a thickness of at least one of the first electrode layer 21, the second electrode layer 22, and the third electrode layer 23 may be less than or equal to one tenth of a wavelength (a wavelength of a sound wave passing through the electrode layer 20), so that a degree of attenuation when the sound wave passes through the electrode layer 20 can be effectively reduced, and performance of the ultrasonic sensor 100 can be improved.

For example, refer to FIG. 14. The fabrication method may further include the following.

S7: Form a protective layer 60 on a side of the third electrode layer 23 that faces away from the substrate 10.

It may be understood that, this step may further include: forming a first bonding layer 70 between the protective layer 60 and the third electrode layer 23.

It may be understood that the method for fabricating the ultrasonic sensor 100 provided in this embodiment of this application may further include steps of forming other structures of the ultrasonic sensor 100 provided in the foregoing embodiments, for example, a step of forming the contact layer 80. Details are not described herein again.

For example, the electrode layer 20 may be fabricated through sputtering, physical or chemical deposition, distillation, silkscreen, or the like.

For example, fabrication of the piezoelectric layer 30 may be implemented by using the following embodiment.

FIG. 15 is a flowchart of fabricating the piezoelectric layer 30.

As shown in FIG. 15, the step of forming the piezoelectric layer 30 may include the following.

K1: Form a piezoelectric thin film. For example, the piezoelectric thin film may be fabricated through scraping coating or spin coating of a piezoelectric material.

K2: Anneal the piezoelectric thin film. In this way, crystallization of the piezoelectric thin film is implemented, so that a complete molecular chain is formed inside the piezoelectric thin film, to facilitate subsequent polarization.

In the annealing process, an annealing temperature of the piezoelectric thin film that is farther away from the substrate 10 is less than a Curie temperature of the piezoelectric thin film that is closer to the substrate 10, avoid a depolarization defect of the piezoelectric layer 30 that is closer to the substrate 10 caused by an annealing process of the piezoelectric layer 30 that is farther away from the substrate 10.

K3: Polarize the piezoelectric thin film to form the piezoelectric layer 30. For example, polarization may be implemented in a manner such as corona polarization or contact polarization.

According to the fabrication method provided in the foregoing embodiment of this application, a problem of mutual restriction between the annealing temperature and the Curie temperature in a process of fabricating the plurality of piezoelectric layers 30 is resolved. In addition, the fabrication method is simple, and mass production of the ultrasonic sensor 100 can be implemented. In addition, the obtained ultrasonic sensor 100 has good performance and low costs, and has a good application prospect.

The foregoing descriptions are merely specific implementations of this application, but are not intended to limit the protection scope of this application. Any variation or replacement readily figured out by a person skilled in the art within the technical scope disclosed in this disclosure shall fall within the protection scope of this application. Therefore, the protection scope of this application shall be subject to the protection scope of the claims.

## Claims

1. An ultrasonic sensor, comprising:
a substrate; and
a plurality of electrode layers and a plurality of piezoelectric layers that are disposed on a same side of the substrate, wherein the electrode layers and the piezoelectric layers are alternately stacked, and each piezoelectric layer is disposed between two adjacent electrode layers, wherein
Curie temperatures of the piezoelectric layers gradually decrease in a direction away from the substrate.

2. The ultrasonic sensor according to claim 1, wherein a difference between Curie temperatures of two adjacent piezoelectric layers is 5°C to 20°C.

3. The ultrasonic sensor according to claim 1 or 2, wherein an annealing temperature of a piezoelectric layer farther away from the substrate is less than a Curie temperature of a piezoelectric layer closer to the substrate.

4. The ultrasonic sensor according to any one of claims 1 to 3, wherein an electrode layer located between the two adjacent piezoelectric layers is a preset electrode layer, a thickness of the preset electrode layer is less than or equal to 0.1λ₁, and λ₁ is a wavelength of a sound wave passing through the preset electrode layer.

5. The ultrasonic sensor according to any one of claims 1 to 4, wherein in the plurality of electrode layers, a thickness of each electrode layer is less than or equal to 0.1λ, and λ is a wavelength of a sound wave passing through the electrode layer.

6. The ultrasonic sensor according to any one of claims 1 to 5, wherein a sum of a thickness-to-wavelength ratio of the plurality of piezoelectric layers and a thickness-to-wavelength ratio of the plurality of electrode layers is 0.15N to 0.35N, and N is an odd number.

7. The ultrasonic sensor according to claim 6, wherein the sum of the thickness-to-wavelength ratio of the plurality of piezoelectric layers and the thickness-to-wavelength ratio of the plurality of electrode layers is 0.25N, and N is an odd number.

8. The ultrasonic sensor according to any one of claims 1 to 7, wherein a sum of a thickness-to-wavelength ratio of the substrate, the thickness-to-wavelength ratio of the plurality of piezoelectric layers, and the thickness-to-wavelength ratio of the plurality of electrode layers is 0.35M to 0.65M, and M is an integer.

9. The ultrasonic sensor according to any one of claims 1 to 8, further comprising:
a protective layer, stacked on a side that is of an electrode layer farthest away from the substrate and that faces away from the substrate, wherein the protective layer is insulated from the electrode layer.

10. The ultrasonic sensor according to claim 9, wherein a material of the protective layer comprises a metal material.

11. The ultrasonic sensor according to claim 9 or 10, wherein from the protective layer to an electrode layer closest to the substrate, a sum of thickness-to-wavelength ratios of all film layers is 0.15 N to 0.35 N, and N is an odd number.

12. The ultrasonic sensor according to any one of claims 9 to 11, further comprising:
a contact layer, stacked on a side of the substrate that faces away from the protective layer, or stacked on a side of the protective layer that faces away from the substrate.

13. The ultrasonic sensor according to any one of claims 1 to 12, further comprising:
a circuit layer, disposed between the electrode layer closest to the substrate and the substrate, wherein the circuit layer comprises a plurality of spaced pixel circuits; and
in the plurality of electrode layers, the electrode layer closest to the substrate comprises a plurality of spaced electrode blocks, and the plurality of electrode blocks are correspondingly electrically connected to the plurality of pixel circuits.

14. The ultrasonic sensor according to any one of claims 1 to 13, wherein in the plurality of electrode layers, two spaced electrode layers are electrically connected, and one electrode layer is disposed between the two electrode layers that are electrically connected.

15. The ultrasonic sensor according to claim 14, further comprising:
a first side edge trace and a second side edge trace, respectively disposed on two sides of the plurality of electrode layers in a first direction, wherein the first direction is parallel to the substrate; and
the plurality of electrode layers comprises a plurality of first sublayers and a plurality of second sublayers, the first sublayers and the second sublayers are alternately stacked, two adjacent first sublayers are electrically connected through the first side edge trace, two adjacent second sublayers are electrically connected through the second side edge trace, the first side edge trace is insulated from the second sublayer, and the second side edge trace is insulated from the first sublayer.

16. A method for fabricating an ultrasonic sensor, comprising:
forming a plurality of electrode layers and a plurality of piezoelectric layers on a same side of a substrate, wherein the electrode layers and the piezoelectric layers are alternately stacked, each piezoelectric layer is disposed between two adjacent electrode layers, and Curie temperatures of the piezoelectric layers gradually decrease in a direction away from the substrate; and
forming the piezoelectric layer comprises:
forming a piezoelectric thin film;
annealing the piezoelectric thin film, wherein an annealing temperature of a piezoelectric thin film farther away from the substrate is less than a Curie temperature of a piezoelectric thin film closer to the substrate; and
polarizing the piezoelectric thin film to form the piezoelectric layer.

17. An electronic device, comprising:
the ultrasonic sensor according to any one of claims 1 to 15; and
a circuit board coupled to the ultrasonic sensor.
